# EUROPEAN PATENT SPECIFICATION

(11) **EP 0 320 217 B1**
(45) Date of publication and mention of the grant of the patent: **01.05.1996**
(21) Application number: 88311554.5
(22) Date of filing: 06.12.1988
(51) Int. Cl.: H01L 21/82, H01L 27/06, H01L 21/285

(54) **An improved twin-well BiCMOS process**
Verfahren zum Herstellen eines Twin-well-BICMOS-Transistors
Procédé pour fabriquer un transistor du type twin-well-BICMOS

(30) Priority: 07.12.1987 US 129271
(43) Date of publication of application: 14.06.1989
(73) Proprietor: TEXAS INSTRUMENTS INCORPORATED, Dallas Texas 75265 (US)
(72) Inventor: Eklund, Robert H., Plano Texas 75023 (US); Havemann, Robert H., Garland Texas 75042 (US); Haken, Roger A., Dallas Texas 75229 (US); Scott, David B., Plano Texas 75075 (US)
(74) Representative: Abbott, David John

(56) References cited:
- EP-A- 0 097 379
- EP-A- 0 151 347
- EP-A- 0 215 583
- US-A- 4 604 790
- US-A- 4 637 125
- VLSI Technology, by S.M. Sze, MacGraw-Hill, USA, 1988

## Description

This invention is in the field of integrated circuits, and is specifically directed to methods of fabricating bipolar and CMOS transistors in the same integrated circuit.

### Background of the Invention

As is well known in the art, digital and linear functions are often performed by integrated circuits using either bipolar or metal-oxide-semiconductor (MOS) technology. Bipolar integrated circuits, of course, provide higher speed operation and greater drive currents than the MOS circuits, at the cost of higher power dissipation, especially when compared against complementary MOS (CMOS) circuits. Recent advantages in manufacturing technology have allowed the use of both bipolar and CMOS transistors in the same integrated circuit (commonly referred to as BiCMOS devices). An example of a BiCMOS structure is described in EP-A-0 278 619 assigned to Texas Instruments Incorporated.

The formation of BiCMOS devices may of course be accomplished by forming the bipolar transistors according to known techniques in selected areas of the device, by forming the MOS transistors according to known techniques in selected areas of the device, and interconnecting the two types of transistors. However, certain features of each type of transistor tend to be incompatible, from a process standpoint, with the other type, requiring a large number of process steps to form each. It is therefore preferable in the manufacture of such BiCMOS circuits to utilize structures which are useful in both types of transistors, in order to minimize the process complexity and cost. Such dual utilization of structural components and process steps, however, generally results in a process which is less than optimal for either the bipolar or the MOS transistors, or both.

It is therefore an object of this invention to provide a manufacturing process for BiCMOS integrated circuits which provides improved MOS performance due to reduced degradation of mobility in the n-channel MOS transistors, at no added process complexity.

It is yet another object of this invention to provide such a process which results in a BiCMOS structure having improved latchup immunity.

It is yet another object of this invention to provide such a process which results in a structure having reduced body effect in the MOS transistors, and lower collector-base capacitance in the bipolar transistors.

In US-A-4 637 125 and in a EP-A-0097379 there are disclosed methods for fabricating integrated circuits having both CMOS transistors and bipolar transistors. In both these disclosures the transistors are formed in wells of different conductivity types in an epitaxial layer and the gate electrodes are formed from polysilicon. Both disclose vertical bipolar transistors with the emitter region being formed by diffusion of dopant from the polysilicon emitter contact which makes contact with the epitaxial layer through a window in a portion of an oxide layer that serves elsewhere as the gate oxide of the CMOS transistors.

Prior methods for forming the bipolar transistors in such structures, such as described in said EP-A-0 278 619, US-A-4,637,125 and EP-A-0097379, have incorporated thin oxide layers between the diffused base region and the overlying emitter electrode (generally formed of polysilicon). The thin oxide over the base is generally formed in the same step as the gate oxide for the MOS transistors, and therefore is generally of a thickness on the order of 20 nm.

Such thin oxides separating the base region from the emitter electrodes cause certain problems, however. Firstly, performance of the bipolar transistors degrades as the emitter-to-base capacitances increases. Of course, such capacitance increases as the dielectric thickness therebetween decreases, making it preferable to have a thicker dielectric between the emitter and the base region. In addition, a thin dielectric between the emitter electrode and the base region is inherently weaker to stress from subsequent processing steps such as contact etch, silicidation, and metal deposition and sinter. Furthermore, a thin dielectric also increases the risk that a contact via formed over the oxide for connecting an overlying metallization layer to the emitter electrode will leak to the base region. This can occur in the event that the contact via is overetched through the emitter electrode, in which case the dielectric under the emitter electrode will be further thinned, in turn further increasing the emitter-to-base capacitance. In extreme cases, the dielectric may be etched completely through, shorting the overlying metal and the emitter electrode to the base region.

The method described in the above-referenced EP-A-0278619 using the thin MOS gate oxide dielectric over the base region, avoids the stress and overetch problems by making contact to the polysilicon emitter electrode at a location away from the contact to the base region. Such a configuration does not address the emitter-to-base capacitance problem, and adds the disadvantage of increasing the emitter resistance.

It is therefore an object of this invention to provide a process for forming a BiCMOS structure which incorporates a substantially thicker dielectric layer between the base and emitter of the bipolar transistors.

It is yet another object of this invention to provide such a process which provides such a thicker dielectric in a manner compatible with the formation of the MOS transistors in the same structure, and without requiring an additional masking step to form the thicker oxide over the base region.

It is yet another object of this invention to provide such a process which can be used to form diffused resistors as well as the bipolar transistor base region.

Other objects and advantages of the invention will be apparent to those of ordinary skill in the art having reference to the following specification in conjunction with the drawings.

### Brief Description of the Drawings

Figures 1 through 6, Figures 8 through 14, and Figures 16 and 17 are cross-sectional views of a BiCMOS semiconductor structure in various states of fabrication, according to the process of the invention.

Figures 7a through 7e are cross-sectional views of a BiCMOS semiconductor structure illustrating various states of the fabrication of trench isolation, according to an alternate embodiment of the invention.

Figures 15a and 15b are cross-sectional views of a diffused resistor in various states of fabrication, according to the process of the invention.

Figure 18 is a plan view of the structure of Figure 17.

### Summary of the Invention

In one embodiment the invention may be incorporated in a process for manufacturing an integrated circuit having both bipolar and CMOS transistors. A buried n+ layer is formed in selected areas of a p-type region, and a thin intrinsic epitaxial layer is formed thereupon. N-wells and p-wells are implanted and diffused into the epitaxial layer, into which the p-channel and n-channel MOS transistors, respectively, will be formed. The intrinsic epitaxial layer reduces the counterdoping required for formation of the p-well, providing for greater electron mobility in the channel region of the n-channel MOS transistors.

In another embodiment the invention may be incororated into a method for fabricating a semiconductor device, by defining the base region of a bipolar transistor with a masking layer covering the portions of the surface other than the base region. The masking layer contains silicon nitride, for prevention of oxidation. A relatively thick oxide layer is then grown over the intended base region, and the base dopant is implanted therethrough; the masking layer must also be sufficiently thick to block the base implant. After implant of the base region, the masking layer may be removed, and the emitter region may be formed by way of polysilicon autodoping, or by another implant. The same process may be used to form diffused resistors, with a polysilicon layer used to define the resistor, and with a more heavily doped diffusion at each end of the diffused region for making contact to the resistor. The polysilicon also serves to block the siliciding of the resistor.

According to claim 1 of the present invention there is provided a method of fabricating in the surface of a silicon body an integrated circuit including field-effect transistors having channels of differing conductivity types and bipolar transistors, the transistors being formed in regions having differing conductivity types, the method including the steps of:
(a) forming in the surface of a silicon body heavily doped n⁺ type first regions adjacent p type second regions,
(b) depositing an epitaxial layer on the surface of the silicon body so as to bury the first and second regions,
(c) forming a mask of silicon nitride on a silicon oxide layer prior deposited on the surface of the epitaxial layer,
(d) implanting an n type dopant through windows in the mask into the epitaxial layer so as to form n type first wells (20) overlying the n⁺ type first regions in the silicon body,
(e) growing oxide on the unmasked parts of the surface of the epitaxial layer,
(f) removing the silicon nitride,
(g) implanting a p type dopant into the epitaxial layer using the grown oxide as a mask so as to form p type second wells self-aligned with the n type first wells overlying the p type second regions in the silicon body,
(h) driving the conductivity determining dopants of the first and second wells into the epitaxial layer so that the n type wells meet the n⁺ type buried regions to form combined n type regions and the p type wells meet the p type buried regions to form combined p type regions, and
(i) forming transistors in the combined n type regions and the combined p type regions,
characterised in that the epitaxial layer deposited in step (b) is of a very lightly n-type doped substantially intrinsic silicon having a resistivity greater than 10 ohm cm.

### Detailed Description of the Preferred Embodiment

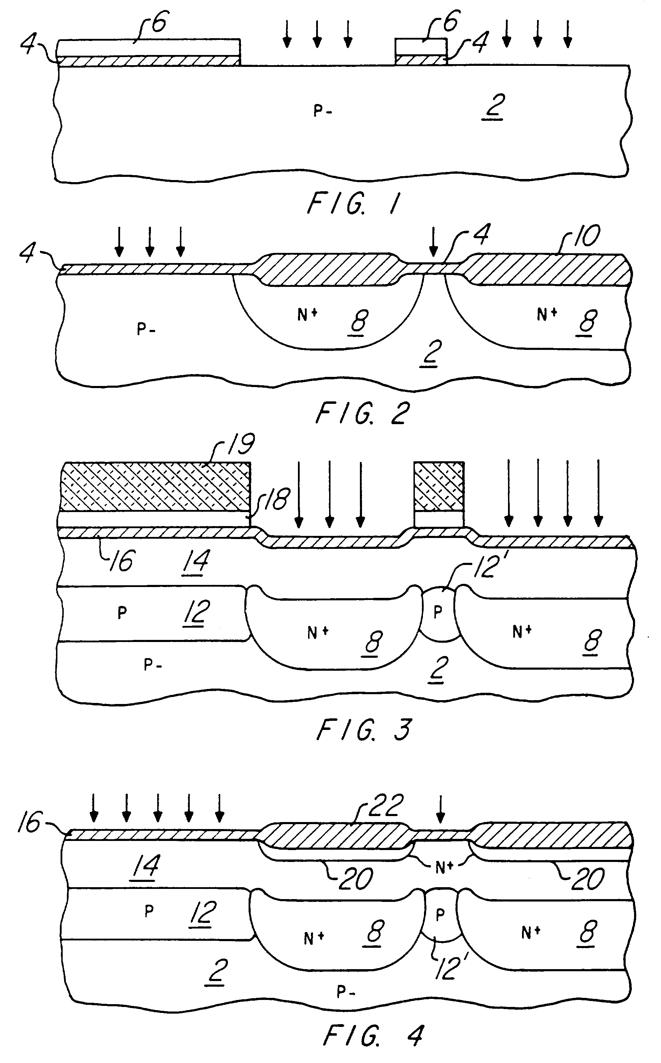

Figure 1 is a cross-sectional view of a lightly doped p-type single crystal silicon substrate 2 in wafer form, shown prior to the formation of a buried n-type layer. A masking layer consisting of silicon oxide layer 4 covered by silicon nitride layer 6 is formed according to any one of a number of well-known techniques; for example, silicon oxide layer 4 may be a grown oxide having a nominal thickness of 50 nm, and nitride layer may be a deposited by low pressure chemical vapor deposition (LPCVD) to nominally 100nm thick. Layers 4 and 6 are patterned as shown in Figure 1, and serve as a mask for the implant of the buried n+ region, such an implant indicated by the arrows of Figure 1. The photoresist (not shown) used for the patterning of masking layers 4 and 6 is preferably removed prior to the heavy-dose buried n+ ion implantation. An example of an implant for forming the buried n+ region in this embodiment is an antimony implant at an energy on the order of 40 keV with a dose on the order of 5E15 ions/cm.

After the implant step, the diffusion of the antimony to form buried n+ region 8 occurs during a high temperature anneal, such as at 1250 degrees Celsius for 30 minutes, as is typically required for antimony diffusion. The resultant depth of buried n+ region 8 is in the range of 2 to 3 microns. Of course other dopants such as arsenic may be used to form buried n+ region 8, which may be driven with a lower temperature anneal (e.g., 1000 degrees Celsius for arsenic). Thick oxide regions 10 are also formed during this step in the locations not covered by nitride layer 6, to a thickness of between 250 and 300 nm. The masking nitride layer 6 is then stripped after the anneal.

Thick oxide regions 10 of Figure 2 serve as a mask to the ion implant for forming buried p-type regions. Accordingly, a boron implant (indicated in Figure 2 by the arrows) is performed, for example at an energy in the range of 40 to 70 keV with a dose in the range of 5E12 to 2E13 ions/cm. An anneal step is then performed to drive the implanted boron, such an anneal being done at a temperature of 900 to 950 degrees Celsius for a period of from 30 to 60 minutes, depending upon the depth desired; in this embodiment, the depth of buried p region 12 is approximately 1 micron. It should be noted that the provision of buried p-regions by this implant is not essential in fabricating an operable device, as a p-type substrate 2 of sufficient doping concentration to prevent punch-through between adjacent buried n+ regions 8 could alternatively be used, without the need for a buried p-type region. Omission of the buried p-type regions also would allow the use of a thick oxide layer as the n+ implant mask, rather than the nitride/oxide sandwich of layers 4 and 6 described above.

In addition, it should be noted that the use of thick oxide layers 10 to mask the boron implant results in a buried p-type region which is adjacent to and self-aligned with buried n+ region 8, without requiring another mask and pattern step. Of course, such an additional mask and pattern step prior to the boron implant may alternatively be used if a space between the eventual p-type buried region and buried n+ region 8 is desired.

Figure 3 illustrates buried p-type region 12 formed adjacent to buried n+ region 8; p-type region portion 12′ lying in a narrow space between adjacent buried n+ regions 8 is not of sufficient size to eventually include a p-well, but will serve instead as an isolation region between the adjacent buried n+ regions 8. Subsequent to the boron implant described above, thick oxide layer 10 (as well as oxide 4) is stripped, and epitaxial layer 14 is grown according to well known techniques. Epitaxial layer 14 in this embodiment of the invention is very lightly doped n-type material (i.e., greater than 10 ohm-cm), so as to be substantially intrinsic silicon. As will be described below, epitaxial layer 14 will be selectively implanted to form p-type and n-type wells into which both the MOS and bipolar transistors will be formed. For the benefit of the bipolar transistors, epitaxial layer 14 is kept relatively thin (for example, on the order of 0.75 to 1.50 microns) so that the length of the portion of the collector which is in the n-well (between a diffused base region and buried n+ region 8 ) is minimized, reducing the collector resistance.

A thin layer (e.g., 35 nm) of oxide 16 is grown on the surface of epitaxial layer 14, followed by LPCVD nitride layer 18 of an approximate thickness of 100 nm deposited thereupon. Nitride layer 18 is then patterned by photoresist layer 19 as shown in Figure 3, to serve as a mask for the n-well implant (shown by the arrows of Figure 3), in a manner similar to nitride layer 6 described above. Oxide 16 may remain as a passivation layer over the regions into which the implant will occur, since the energy of the n-well implant is high enough to place the dopant into epitaxial layer 14 through oxide 16.

The ion implantation for forming the n-wells in epitaxial layer 14 may be done by a single ion implant operation, or by multiple implants, depending upon the dopant profile desired in the n-well. In this embodiment of the invention, a dual n-well implant is then performed using a low energy phosphorous implant followed by a high-energy phosphorous implant. For example, the first implant may be a dose of 1E12 ions/cm at 70 keV, and the second implant may be done at 350 keV with a dose on the order of 1.2E12 ions/cm. Of course, the n-well implant or implants may be significantly altered from that described herein, depending upon the desired dopant profile. The dual implant is followed by an oxide growth step, performed in a steam atmosphere at 900 degrees Celsius for 30 minutes, resulting in oxide layer 22 having a thickness on the order of 350 nm, covering the regions receiving the n-well implant. Nitride oxidation mask layer 18 is then stripped, and the p-well is implanted, masked by oxide regions 22 overlying the n-well regions 20. The p-well implant is a boron implant, for example having a dose of 1E12 ions/cm at 50 keV, and is indicated by the arrows in Figure 4.

Following the p-well implant, both the n-well and p-well implants are driven to the desired depth. For example, a 150 minute drive in an N₂/O₂ environment at 1000 degrees Celsius will typically result in a well depth of approximately 1 micron, for the implant doses and energies described hereinabove. As discussed above, prior BiCMOS fabrication methods utilized n-type epitaxy (for example, on the order of 1 ohm-cm or less), allowing for either omission or dose reduction of the n-well implant. For example, an n-well can be formed into an 0.5 ohm-cm epitaxial layer by way of a single low energy phosphorous implant, in order to minimize the potential of implant damage in the n-well regions (which will eventually contain n-p-n bipolar transistors). However, formation of the p-well in such an epitaxial layer requires counterdoping of the n-type epitaxial layer into p-type. As is well known in the art, this counterdoping degrades the carrier mobility of the resulting layer; since the p-well will be used in the channel region of the n-channel MOS transistors, the performance of the n-channel MOS transistors is accordingly degraded by such counterdoping. As is well known, n-channel transistors in a CMOS device generally have faster switching times than the p-channel transistors, due to the greater carrier mobility in the channel region; CMOS designs thus generally use n-channel MOS transistors as much as possible in speed-critical functions. Accordingly, degradation of carrier mobility in the channel region of the n-channel transistors in a CMOS or BiCMOS circuit will directly impact the performance of the circuit. The use of the intrinsic epitaxial layer 14 according to this embodiment of the invention reduces the mobility degradation in p-well 24 by minimizing the counterdoping required in its formation. Formation of n-well 20 in intrinsic epitaxial layer 14 according to the above-described method has not resulted in noticable implant damage or degradation of the bipolar transistors.

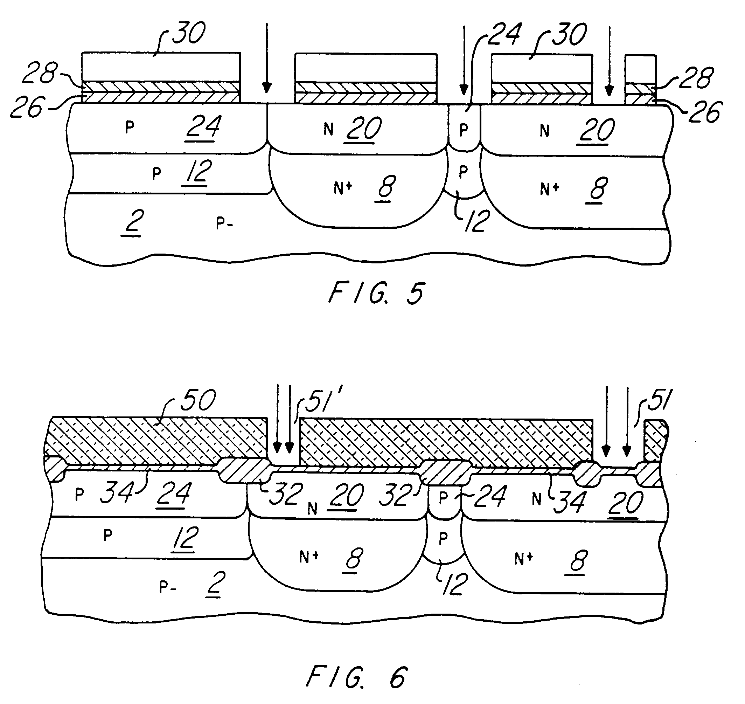

Oxide regions 22 and such oxide as is formed in the drive step are then stripped, leaving the n-well regions 20 and p-well regions 24 as shown in Figure 5. As in the case of the formation of the buried p-type regions 12, p-well regions 24 are formed self-aligned with n-well regions 20.

This embodiment further includes additional isolation regions between the p-well regions 24 and n-well regions 20. Accordingly, after the oxide regions 22 are etched, a 10 nm layer 26 of silicon dioxide is grown, upon which is deposited a buffer polysilicon layer 28, having a thickness of approximately 50 nm. LPCVD nitride layer 30 is then deposited upon polysilicon 28, and the nitride/polysilicon/oxide sandwich is then patterned to expose the isolation regions. The benefits of polysilicon layer 28 as a buffer in the formation of LOCOS isolation are described in U.S.-A-4,541,167, issued September 17, 1985 and assigned to Texas Instruments Incorporated. After exposure of the isolation regions, a channel-stop is implanted to supplement the p-well boron concentration in p-wells 24 near the surface. This supplementation overcomes the segregation of boron from (p-wells 24 into the isolation oxide regions during formation such formation described below). An example of such an implant is a boron implant of a dose in the range of 3E12 to 5E12 ions/cm, at an energy on the order of 40 keV. However, it should be noted that portions of n-wells 20 also receive this implant (unless a separate masking step is performed), requiring optimization of the channel-stop implant dose to adequately compensate the boron segregation from p-wells 24 (i.e., to keep the field oxide threshold voltage high in p-wells 24) while avoiding overcompensating the portions of n-wells 20 receiving the implant (i.e., to keep the field oxide threshold voltage high in n-wells 20). A high pressure oxidation step (e.g., 52 minutes in a steam environment at 10 atmospheres pressure and 900 degrees Celsius) is then performed to form the recessed isolation oxide layers 32, such oxidation masked by nitride layer 30 over the active regions of the structure. It should of course be noted that any one of a number of known techniques for forming field oxide layers may be used to form oxide layers 32 (for example, more or less recess may be desirable, the poly buffering may be omitted, or formation of the oxide may occur at a different temperature or at atmospheric pressure); the method described in said U.S.-A-4,541,167 is preferable, for the reasons described therein.

Referring now to Figure 6, the resultant recessed isolation oxide regions 32 are illustrated. The thickness of oxide regions 32 formed by the above process is preferably at least 700 nm. Nitride layer 30, buffer polysilicon layer 28, and oxide layer 26 are etched according to conventional techniques, clearing the surface of the wafer. A thin pregate oxide, or dummy gate oxide, layer 34 is then grown to a thickness of the order of 20 nm for protection of the silcon surface during subsequent process steps leading up to the formation of the actual gate dielectric.

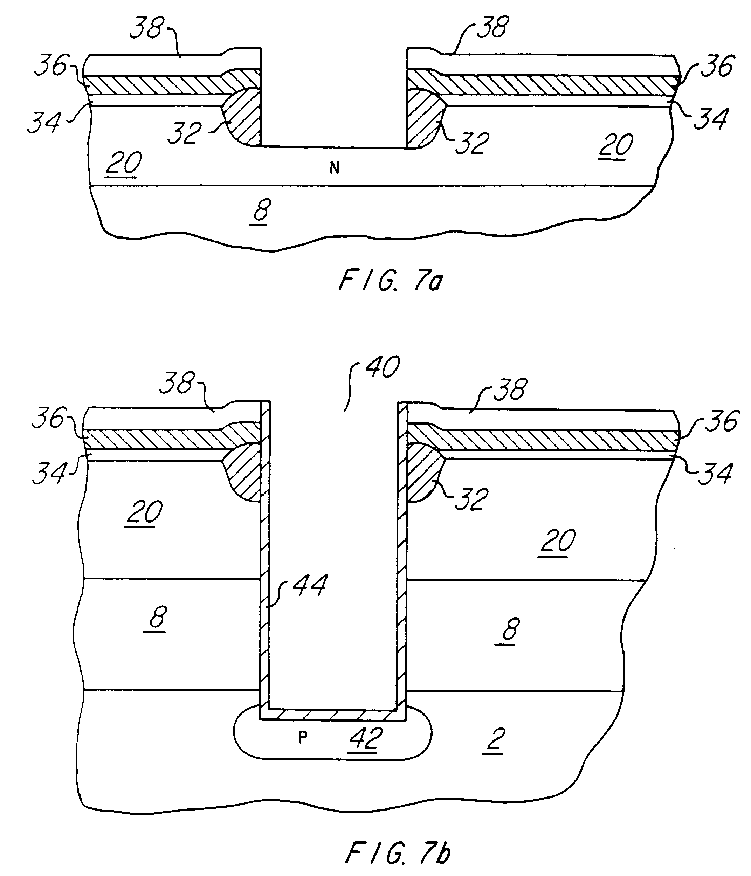

In operation, p-wells 24 and n-wells 20 will be biased so that the junctions therebetween will be reverse-biased, serving to isolate the wells from one another. Accordingly, a portion of a p-well 24 may be disposed between two n-wells 20 for isolating the two n-wells 20 from one another; an example of the need for such isolation is for isolating an n-well 24 which will contain MOS transistors from an n-well 24 which will contain bipolar transistors. An alternative to such junction isolation between wells is the use of trench isolation. Figures 7a through 7e illustrate the formation of such trench isolation into the structure of Figure 6, used in the example of isolating two n-wells 20 from one another. Such trench isolation is preferable over junction isolation in certain situations, for example, where the additional process cost to form the trenches is outweighed by the added performance from reduced sidewall capacitance (of the trench versus the reverse-biased junctions), or by the savings of wafer surface area of the trench scheme due to tighter packing density allowed by trench isolation. Referring to Figure 6a, after the growth of oxide layer 34 a buffer layer of polysilicon 36 is deposited by LPCVD to a thickness on the order of 250 nm. A layer of TEOS oxide 38, having a thickness on the order of 1 micron, is then deposited on top of the buffer polysilicon layer 36 to serve as hard mask material for the etch of the trench. Photoresist (not shown) is then used to define the pattern for the trench, after which TEOS oxide 38, polysilicon layer 36, oxide layer 34 and field oxide 32 are etched to expose a portion of n-well 20 through which the isolating trench is to be formed. Figure 7a shows the result of the formation of the hard trench mask.

Following the formation of the hard mask, a trench 40 is etched through recessed oxide layer 32 and through n-well 20 by way of reactive ion etch (RIE), according to well known trench etch techniques. The trench is preferably extended beyond the depth of buried n+ region 8 to a depth reaching substrate 2. A first sidewall layer of oxide (not shown) is grown in trench 40, to a thickness of approximately 100 nm, serving in a role similar to a dummy gate oxide. A channel stop implant is performed into the bottom of the trench 40, through the first sidewall oxide, to form channel-stop region 42 thereat. The first sidewall oxide layer is then stripped, and a 100 nm layer 44 of oxide is regrown on the sidewalls and bottom of trench 40, as shown in Figure 7b.

After regrowth of the sidewall oxide layer 44, trench 40 is filled with a polysilicon plug 46, formed by CVD of a polysilicon layer over the entirety of the wafer. A planarization etch of the polysilicon layer is performed until TEOS oxide layer 38 is reached, stopping the etch at the surface of the wafer; the etch is continued so that the polysilicon plug 46 inside trench 40 is recessed to a predetermined depth (e.g., in a range of 0.5 to 1.0 microns), as shown in Figure 7c.

The formation of the trench isolation is completed by deposition of a second TEOS oxide layer 48 over the entirety of the wafer, filling the recess in trench 40 caused by the overetch of polysilicon plug 46. TEOS oxide layer 48 is then etched back until polysilicon layer 36 is reached at the surface of the wafer away from trench 40, so that TEOS oxide 48 is planarized with the top of recessed oxide layer 34 near the trench, providing the structure of Figure 7d.

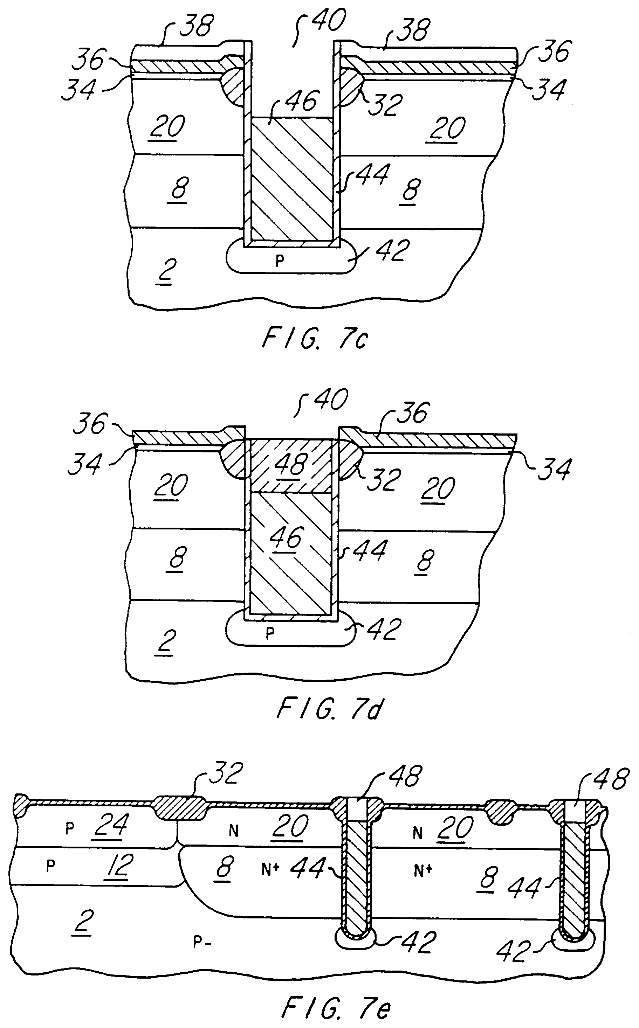

The filling of trench 40 with a polysilicon plug 46 provides a structure which adds minimal stress to the integrated circuit, since polysilicon and single crystal silicon expand and contract at substantially the same rate during temperature cycling. It should be noted that the trench structure resulting from the method described above relative to Figures 7a through 7d allows for subsequent metal-to-metal or metal-to-poly contacts to be made directly above trench 40, because the thick oxide within the recess of trench 40 minimizes the risk of overetching the contact via into polysilicon plug 46 and causing leakage thereinto from the overlying layer. Such a structure thus removes the requirement that contacts be spaced away from the top of trench 40, such a requirement often resulting in additional wafer area merely for contact spacing rules to be obeyed. It should further be noted that prior techniques used to oxidize the top of the trench without recessing the polysilicon plug 46 resulted in bird's-beak formation near the surface of the structure, adding stress-induced leakage potential at the silicon-silicon oxide interface at the top of trench 40. The formation of the TEOS oxide cap 48 of Figure 7d thus provides for a low stress fill of the trench, so that contacts may be made directly thereabove with minimal stress-induced leakage occuring at or near the top of trench 40. Figure 7e illustrates such trench isolation as incorporated into the structure of Figure 6.

It should be noted that the trench isolation method described hereinabove relative to Figures 7a through 7d is also useful in the fabrications of totally bipolar integrated circuits, for the same reasons as described above. In such an application, field oxide regions 32 would not necessarily be present, requiring only the hard mask provided by oxide layer 38.

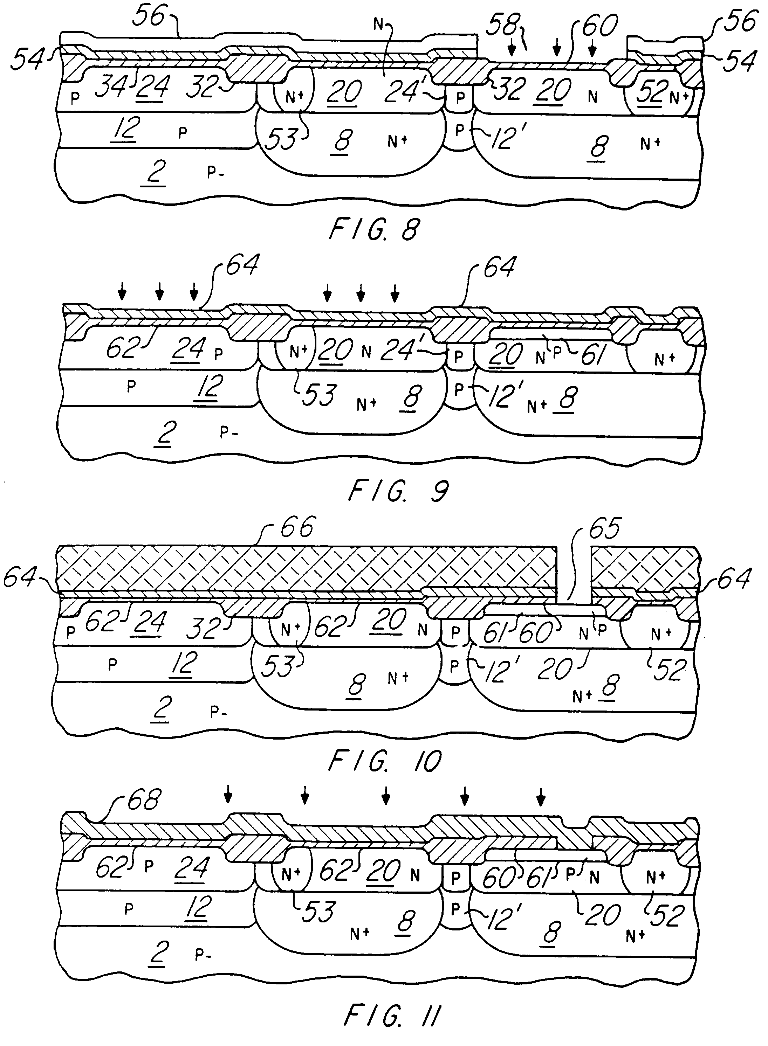

As is well known in the art, buried n+ regions 8 are especially suitable for collector electrodes of bipolar transistors. Referring back to Figure 6, photoresist layer 50 is shown as patterned to expose a portion 51 of n-well region 20 in which bipolar transistors will be formed for an n-type implant (indicated by the arrows of Figure 7) of the deep collector contact from the surface of n-well region 20 to buried n+ region 8. In addition, a direct contact through n-well 20 to buried n+ region 8 is preferable for n-wells 20 containing MOS transistors, for purposes of reducing latchup susceptibility; accordingly, a portion 51′ of another n-well 20 is exposed to receive the deep collector implant. An exemplary deep collector implant is a high energy (on the order of 150 keV) phosphorous implant, with a dose in the range of 5E15 to 2E16 ions/cm. The resultant deep collector contact 52 is illustrated in Figure 8.

As shown in Figure 8, photoresist layer 50 is then stripped, prior to definition of the mask layer for formation of the base region of the bipolar transistors. An LPCVD polysilicon layer 54 is first deposited to a thickness on the order of 100 nm to minimize stress-induced defects in a similar fashion as described in the above-referenced U.S.-A-4,541,167 for poly-buffered LOCOS isolation. The deposition of polysilicon 54 is then followed by the deposition of LPCVD nitride layer 56, to a thickness on the order of 270 nm. Nitride layer 56 and polysilicon layer 54 are then patterned and etched to define the base area at location 58 in the structure of Figure 8.

Once base area 58 is defined by the patterning and etching of layers 54 and 56 as shown in Figure 8, a relatively thick oxide layer 60, for example, from 60 to 150 nm thick, is grown over base area 58. Due to the presence of nitride layer 56, no such oxide 60 is of course grown other than the exposed base area 58. The growth of oxide layer 60 is followed by the boron implant to form the diffused base of the bipolar transistor, such an implant indicated in Figure 8 by the arrows. An exemplary base implant through the thick oxide 60 is a boron implant of a dose of 8E13 ions/cm, at an energy of 80 keV. The thicknesses of pregate oxide 34, polysilicon layer 54 and nitride layer 56 are selected to block the base implant; the above described thicknesses (e.g., 20 nm, 100 nm, and 270 nm, respectively), are noted to be effective to block the above-described base implant. The above implant is effective to form the base region through an oxide layer 60 grown to a thickness of 140 nm. The advantages of the thick oxide layer 60 through which the base implant is made will be described in further detail hereinbelow. This base implant results in base region 61 shown in Figure 9, extending to a depth approximately in the range of 300 to 400 nm from the surface. It should of course be noted that subsequent processing will reduce oxide layer 60 to a final thickness within a range from 40 to 130 nm, depending upon its thickness as grown.

Subsequent to the base implant, nitride layer 56 is cleared by a wet etch, polysilicon layer 54 is removed by a plasma etch, and pregate ("dummy gate") oxide 34 is removed by another wet etch. Referring to Figure 9, gate oxide 62, serving as the gate dielectric for the MOS transistors and, as will be described below, in the patterning of diffused resistors, is then grown to the desired thickness, for example on the order of 20 nm. A preferred method for growth of gate oxide 62 is dry/steam/dry sequence at a temperature of 850 degrees Celsius; for purposes of the instant invention, however, any well known technique may of course be used for growth of the gate oxide 62, including the use of other dielectric materials or combination of materials. A buffer polysilicon layer 64 is then deposited by way of LPCVD to a thickness on the order of 125 nm. As is well known in the art, a threshold voltage adjust ion implant may be done at this time to adjust the threshold voltages of the MOS transistors according to the desired circuit operation. Such an implant (indicated by the arrows in Figure 9) is masked only by the recessed isolation oxide layers 32, and is generally a p-type implant of relatively low (50 keV) energy. Alternatively, the threshold adjust implant may be done through pre-gate oxide 34, prior to the growth of gate oxide 62.

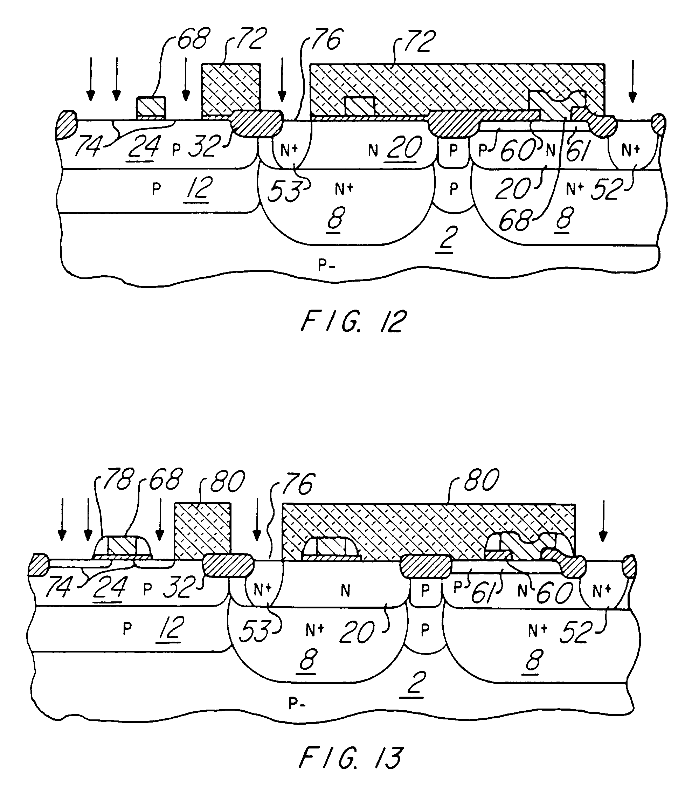

Referring now to Figure 10, a layer of photoresist 66 is shown disposed above the surface of the wafer, patterned to define the location of the emitter for the bipolar transistor. Polysilicon layer 64 and oxide layer 60 above base region 61 are then etched to expose the location 65 of the emitter contact to base region 61. After exposing the emitter contact, photoresist 66 is stripped, and a layer of polysilicon 68 is deposited by LPCVD over the surface of the wafer, contacting base region 61 in the emitter contact area as shown in Figure 11. Polysilicon layer 68 is deposited to a thickness of 325 nm, and will serve as the gate electrode for the MOS transistors, and as an interconnect level, if desired. Polysilicon layer 68 will also serve as the source of the dopant for diffusion of the emitter region into base region 61 of the bipolar transistor, as described below. Polysilicon layer 68 is additive to polysilicon layer 64 at locations not in the emitter contact, resulting in thicker polysilicon at those locations. Polysilicon layer 68 is then doped by way of a phosphorous implant of a dose on the order of 1E16 to 2E16 ions/cm at an energy of 50 keV, as indicated by the arrows in Figure 11.

Referring now to Figure 12, polysilicon layer 68 is shown after being patterned and etched for the formation of the gate electrodes for the MOS transistors and the emitter contact for the bipolar transistor. Subsequent to the polysilicon etch, a layer of TEOS oxide (not shown) may be deposited (e.g., of 30 nm) to passivate the silicon surface and to minimize ion channeling into the source and drain regions during subsequent implant steps; this thin layer of TEOS oxide will also serve to offset the reach-through implant from the polysilicon gate electrode 68, compensating for lateral diffusion of the reach-through implant for better alignment with the edges of gate electrode 68. Photoresist layer 72 is patterned to define the source and drain regions 74 for the n-channel MOS transistor, and for defining the n-well contact 76 to be implanted by a phosphorous reach-through implant (indicated by the arrows in Figure 12). Collector contact 52 and buried n+ region contact 53 also can receive this implant. The reach-through implant is intended to form the shallow and relatively lightly-doped n-type diffusion in the formation of an n-channel MOS transistor having a "lightly-doped-drain" (or graded junction), as described in U.S.-A-4,566,175 issued January 28, 1987 and assigned to Texas Instruments Incorporated. An example of such a reach-through implant is a dose on the order of 2E13 ions/cm at an energy of 80 keV.

Figure 13 illustrates the formation of sidewall oxide filaments 78 on each side of the polysilicon 68. Such formation is accomplished by stripping photoresist 72 (from Figure 12), depositing a conformal layer of TEOS oxide over the wafer (in this example, approximately 200 nm thick), and then anisotropically etching the oxide layer as described in said U.S.-A-4,566,175, leaving the sidewall filaments 78 shown in Figure 13. Thick oxide 60 is also etched at the locations not covered by the emitter polysilicon 68 and sidewall filaments 78. An additional layer of TEOS oxide (not shown) may be deposited as before for passivation of the surface and for reduction of ion channeling during implant, and photoresist 80 is patterned to again expose the n-channel source and drain regions 74, n-well contact 76, and collector contact 52. The source/drain implant is now performed, forming the deeper junction depth for the heavily-doped source and drain of the n-channel MOS transistor; an example of such a source/drain implant (indicated by the arrows in Figure 13) is a high energy arsenic implant (e.g., at 150 keV) having a dose of 3E15 ions/cm, followed by a lower energy phosphorous implant (e.g., at 95 keV) having a dose on the order of 4E14 ions/cm.

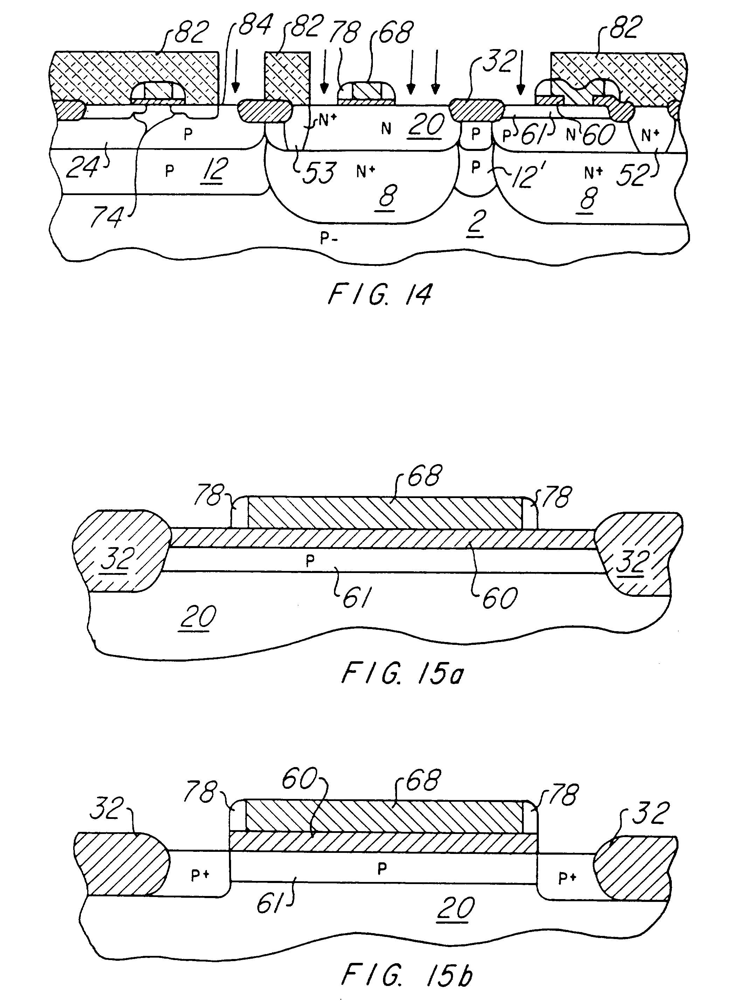

Figure 14 illustrates the formed source and drain regions 74 of the n-channel MOS transistor in p-well 24, as well as the n+ contact 76 in n-well 20. Photoresist 80 is stripped, and a photoresist pattern 82 is formed to define the source-drain regions 84 for the p-channel MOS transistor in n-well 20, as well as p+ contact 85 in p-well 24 and p+ base electrode contact 86 to base region 61. The boron source-drain implant is indicated by the arrows in Figure 14, for example, having a dose of 3E15 ions/cm at an energy of 20 keV.

Referring now to Figures 15a and 15b, the formation of a diffused resistor according to the invention is illustrated. As shown in Figure 15a, the diffused resistor exists in a region receiving the same base implant through oxide layer 60, as shown in Figure 8 (i.e., region 61 of Figure 15a). Deposition and patterning of polysilicon (gate electrode) 68, and formation of sidewall oxide filaments 78 are then performed as described above. This results in the structure of Figure 15a, with polysilicon electrode 68 and sidewall oxide filaments 78 lying above oxide layer 60 over base region 61. Electrical contact is made to the ends of region 61 by patterning and clearing portions of oxide layer 60 outside of the sidewall oxide filaments, and by subjecting the exposed portions to the p+ source/drain implant described above relative to Figure 14, resulting in the structure of Figure 15b. Connection may then be made to the p+ diffusions 88 by any of a number of known techniques. It should be noted that the polysilicon 68 and sidewall filaments 78 will prevent region 61 from becoming silicided (as described hereinbelow), allowing the resistance of the diffused resistor to be defined by the geometry and doping concentration of base region 61.

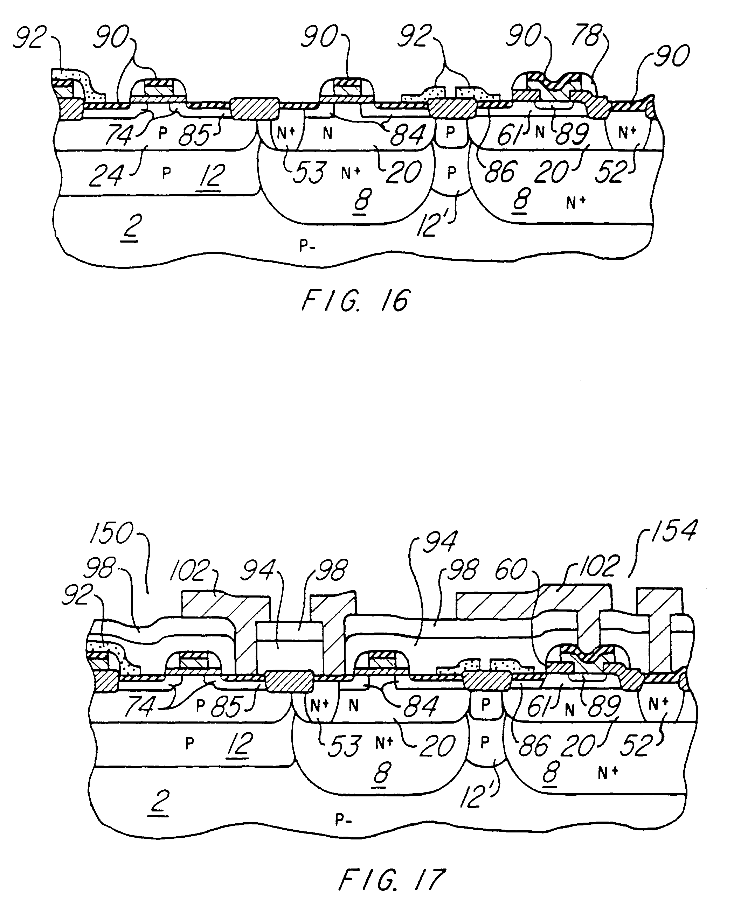

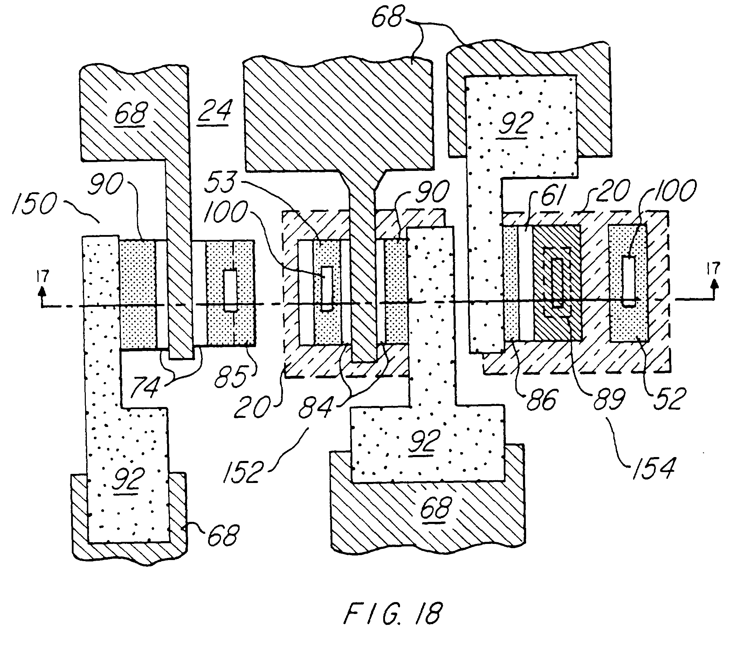

Referring now to Figure 16, after the completion of both the p and n source/drain implants shown in Figure 14, the implanted dopants are driven by a high temperature anneal in an inert atmosphere, such as a 30 minute anneal at 900 degrees Celsius in an argon atmosphere. This anneal not only drives the source/drain implants, but also causes the dopant in polysilicon 68 to diffuse into base region 61, forming emitter region 89 therein, as described in US-A-4 799 099 and also assigned to Texas Instruments Incorporated. The emitter junction depth from such a process is in the range of 100 to 150 nm; the anneal also pushes the depth of base region 61 to a certain extent under the emitter (i.e., "emitter push"). After this source/drain and emitter anneal, any remaining oxide is cleaned from the source, drain and contact regions into which the source/drain implants were made, as well as polysilicon 68. The diffusions may then be silicide-clad if desired, by deposition of a metal such as titanium for a direct reaction with the exposed silicon, followed by an oxide cap, as described in U.S.-A-4,690,730 issued September 1, 1987, assigned to Texas Instruments Incorporated. The result is the formation of titanium silicide layers 90 shown in Figure 17. As described in U.S.-A-4,675,073, issued June 23, 1987 and assigned to Texas Instruments Incorporated, local interconnections 92 may subsequently be made by patterning and etching the unreacted titanium on the silicide and oxide layers, and by exposing the patterned titanium film to a nitrogen atmosphere.

Referring now to Figure 17, the first level of metal interconnect is illustrated as connected to the various locations within the fabricated structure. A multilevel dielectric is formed of a relatively thick (on the order of 1 micron) first layer 94 of LPCVD TEOS oxide. Layer 94 is then planarized and etched back as described in US-A-4 795 722, and assigned to Texas Instruments Incorporated. The planarized TEOS oxide 94 is then coated with a second TEOS oxide layer (e.g., approximately 100 nm thick), followed by a layer of phosphorous doped oxide 98, having a thickness on the order of 300 nm and a phosphorous concentration of 5% by weight. Contact vias are patterned and etched, and the phosphorous-doped oxide 98 is activated and densified by a high temperature anneal, for example 60 minutes at 700 degrees Celsius. A first level metallization 102 may then be deposited to make contact to the various locations in the structure, and may consist of a standard aluminum, or doped aluminum metallization, or of a first layer of titanium tungsten alloy followed by a layer of CVD tungsten. The Ti/W-tungsten system is especially useful in multi-level metal systems; an additional level of metal interconnect may of course be added to the structure of Figure 18, making contacts to first metallization 102 through vias formed according to known techniques.

It should be noted that the thick oxide layer 60 underlying the portion of polysilicon 68 which forms the emitter for the bipolar transistor achieves certain benefits. First, the emitter polysilicon 68 is separated from base region 61 by a greater distance due to the thicker oxide layer 60, reducing the capacitance between the emitter electrode and base region 61, improving the switching speed of the bipolar transistor. In addition, it can be seen that the first metal contact to the emitter electrode is made directly over diffused emitter region 89 in base region 61, saving the surface area required for the formation of the bipolar transistors, as well as reducing the emitter resistance by reducing the length of the current path in the emitter electrode. In prior circuits such stacking of the contact resulted in reliability degradation due to leakage from emitter electrode to base region caused by stressing of the thin dielectric therebetween.

After the first level metallization illustrated in Figure 18, the presence of the two channel-conductivity MOS transistors, well connections, and a bipolar transistor can be easily seen as fabricated into the single substrate 2. N-channel transistor 150 is shown as fabricated into p-well 20 at the left side of Figure 18, having its source region and well contact connected to ground through first level metal 102, and having its drain region contacted by local interconnection layer 92. The p-channel transistor 152 is similarly biased, with its source and well contact connected to the V_{dd} power supply, and its drain region contacted by patterned local interconnect 92. For operation as a CMOS inverter, the gate and drain electrodes of transistors 150 and 152 would be connected together. Bipolar transistor 154 formed into the n-well 20 at the right side of Figure 18 has a subcollector in buried n+ region 8, contacted by first level metal 102 through deep collector contact 52. The emitter region 89 is also contacted by patterned first level metal 102, while base region 61 is contacted by patterned local interconnect layer 92.

Referring now to Figure 18, a plan view is shown of the structure of Figure 17 with metal layer 102 not shown for purposes of clarity. Contact vias 100 are shown in Figure 18, indicating the etched locations of layers 94 and 98 for metal-to-poly and metal-to-diffusion contacts. In this embodiment, n-wells 20 appear as islands in a single p-well 24. Local interconnects 92 are shown to overlap onto polysilicon layers 68, for connection to other locations of the integrated circuit.

## Claims

1. A method of fabricating in the surface of a silicon body an integrated circuit including field-effect transistors having channels of differing conductivity types and bipolar transistors, the transistors being formed in regions having differing conductivity types, the method including the steps of:
(a) forming in the surface of a silicon body (2) heavily doped n⁺ type first regions (8) adjacent p type second regions (12'),
(b) depositing an epitaxial layer (14) on the surface of the silicon body so as to bury the first and second regions,
(c) forming a mask of silicon nitride (18) on a silicon oxide layer (16) prior deposited on the surface of the epitaxial layer,
(d) implanting an n type dopant through windows in the mask into the epitaxial layer so as to form n type first wells (20) overlying the n⁺ type first regions (8) in the silicon body,
(e) growing oxide (22) on the unmasked parts of the surface of the epitaxial layer,
(f) removing the silicon nitride,
(g) implanting a p type dopant into the epitaxial layer using the grown oxide as a mask so as to form p type second wells (24) self-aligned with the n type first wells (20) overlying the p type second regions (12) in the silicon body,
(h) driving the conductivity determining dopants of the first and second wells into the epitaxial layer so that the n type wells meet the n⁺ type buried regions to form combined n type regions and the p type wells meet the p type buried regions to form combined p type regions, and
(i) forming transistors in the combined n type regions and the combined p type regions,
characterised in that the epitaxial layer (14) deposited in step (b) is of a very lightly n-type doped substantially intrinsic silicon having a resistivity greater than 10 ohm.cm.

2. A method according to claim 1 in which the step (a) includes:
providing a silicon body of p type conductivity,
forming a mask in the form of an oxide layer on the surface of the body,
implanting an n type dopant into the surface of the body through the mask,
diffusing the n type dopant into the silicon body to form the n⁺ type first regions, and
removing the oxide masking layer from the surface of the silicon body.

3. A method according to claim 1 in which the step (a) includes:
providing a silicon body (2) of lightly doped p type conductivity,
forming a mask of a silicon oxide layer (4) covered by a silicon nitride layer (6) on the surface of the silicon body,
implanting an n type dopant into the surface of the silicon body through the mask,
annealing the silicon body at high temperature to diffuse the n type dopant into the silicon body to form the n⁺ type first regions, and to form a thick oxide layer (10) on those parts of the silicon body not covered by the silicon nitride masking layer,
removing the silicon nitride masking layer,
implanting a p type dopant into the surface of the silicon body using the thick oxide layer as a mask,
annealing the silicon body to form the p type second regions (12) with the n⁺ type first regions (8), and
removing the silicon oxide from the surface of the silicon body.

4. A method according to claim 1, claim 2 or claim 3 wherein the epitaxial layer (14) has a thickness between 0.75 and 1.5 µm.

5. A method according to any one of the preceding claims including forming additional isolation regions between the n type first wells and the p type second wells by implanting supplementary p type dopant as a channel stop in the isolation regions.

6. A method according to any one of claims 1 to 4 including forming isolating trenches (40) between wells in the epitaxial layer and into the silicon body to a depth beyond the buried regions.

## Patentansprüche

1. Verfahren zum Herstellen einer integrierten Schaltung mit Feldeffekttransistoren, die Kanäle mit unterschiedlichen Leitfähigkeitstypen haben, und bipolaren Transistoren in der Fläche eines Siliziumkörpers, wobei die Transistoren in Zonen mit unterschiedlichen Leitfähigkeitstypen gebildet sind, enthaltend die Schritte:
a) Bilden stark dotierter erster Zonen (8) vom n⁺-Typ angrenzend an zweite Zonen (12') vom p-Typ,
b) Aufbringen einer Epitaxialschicht (14) auf der Fläche des Halbleiterkörpers in der Weise, daß die ersten und zweiten Zonen begraben werden,
c) Bilden einer Maske aus Siliziumnitrid (18) auf einer Siliziumoxidschicht (16) vor dem Aufbringen der Epitaxialschicht auf der Fläche,
d) Implantieren eines Störstoffs vom n-Typ durch Fenster in der Maske in die Epitaxialschicht in der Weise, daß erste Wannen (20) vom n-Typ über den ersten Zonen (8) vom n⁺-Typ in dem Siliziumkörper gebildet werden,
e) Aufwachsen von Oxid (22) auf den unmaskierten Teilen der Fläche der Epitaxialschicht,
f) Entfernen des Siliziumnitrids,
g) Implantieren eines Störstoffs vom p-Typ in die Epitaxialschicht unter Verwendung des aufgewachsenen Oxids als eine Maske in der Weise, daß zweite Wannen (24) vom p-Typ gebildet werden, die mit den ersten Wannen (20) vom n-Typ über den zweiten Zonen (12) vom p-Typ in dem Siliziumkörper selbstjustiert sind,
h) Eintreiben der die Leitfähigkeit bestimmenden Störstoffe der ersten und zweiten Wannen in die Epitaxialschicht in der Weise, daß die Wannen vom n-Typ die begrabenen Zonen vom n⁺-Typ zur Bildung kombinierter Zonen vom n-Typ treffen, und die Wannen vom p-Typ die begrabenen Zonen vom p-Typ zur Bildung kombinierter Zonen vom p-Typ treffen, und
i) Bilden von Transistoren in den kombinierten Zonen vom n-Typ und den kombinierten Zonen vom p-Typ,
dadurch gekennzeichnet, daß die im Schritt (b) aufgebrachte Epitaxialschicht (14) aus sehr leicht n-dotiertem, im wesentlichen eigenleitenden Silizium mit einem spezifischen Widerstand von mehr als 10 Ohm·cm besteht.

2. Verfahren nach Anspruch 1, bei welchem der Schritt (a) enthält:
Erzeugen eines Siliziumkörpers vom p-Leitfähigkeitstyp,
Bilden einer Maske in Form einer Oxidschicht auf der Oberfläche des Körpers,
Implantieren eines Störstoffs vom n-Typ in die Oberfläche des Körpers durch die Maske,
Diffundieren des Störstoffs vom n-Typ in den Siliziumkörper zur Bildung der ersten Zonen vom n⁺-Typ, und
Entfernen der Oxidmaskierungsschicht von der Oberfläche des Siliziumkörpers.

3. Verfahren nach Anspruch 1, bei welchem der Schritt (a) enthält:
Erzeugen eines Siliziumkörpers (2) mit leicht dotierter p-Leitfähigkeit,
Bilden einer Maske aus einer von einer Siliziumnitridschicht (6) bedeckten Siliziumoxidschicht (4) auf der Oberfläche des Siliziumkörpers,
Implantieren eines Störstoffs vom n-Typ in die Oberfläche des Siliziumkörpers durch die Maske,
Tempern des Siliziumkörpers bei hoher Temperatur zum Diffundieren des Störstoffs vom n-Typ in den Siliziumkörper zur Bildung der ersten Zonen vom n⁺-Typ und zur Bildung einer dicken Oxidschicht (10) auf denjenigen Teilen des Siliziumkörpers, die nicht von der Siliziumnitrid-Maskierungsschicht bedeckt sind,
Implantieren eines Störstoffs vom p-Typ in die Oberfläche des Siliziumkörpers unter Verwendung der dicken Oxidschicht als Maske,
Tempern des Siliziumkörpers zur Bildung der zweiten Zonen (12) vom p-Typ mit den ersten Zonen (8) vom n⁺-Typ, und
Entfernen des Siliziumoxids von der Oberfläche des Siliziumkörpers.

4. Verfahren nach Anspruch 1, Anspruch 2 oder Anspruch 3, bei welchem die Epitaxialschicht (14) eine Dicke zwischen 0,75 und 1,5 µm hat.

5. Verfahren nach einem der vorhergehenden Ansprüche, enthaltend die Bildung zusätzlicher Isolationszonen zwischen den ersten Wannen vom n-Typ und den zweiten Wannen vom p-Typ durch Implantieren eines zusätzlichen Störstoffs vom p-Typ als eine Kanalbegrenzung in den Isolationszonen.

6. Verfahren nach einem der Ansprüche 1 bis 4, enthaltend das Bilden von Isolationsgräben (40) zwischen Wannen in der Epitaxialschicht und im Siliziumkörper in eine über die begrabenen Zonen hinausgehende Tiefe.

## Revendications

1. Procédé de fabrication dans la surface d'un corps en silicium d'un circuit intégré comprenant des transistors à effet de champ ayant des canaux de différents types de conductivité et des transistors bipolaires, les transistors étant formés dans des régions ayant des types de conductivités différentes, le procédé comportant les étapes consistant à :
(a) former dans la surface d'un corps en silicium (2) des premières régions (8) de type n⁺ fortement dopées adjacentes à des deuxièmes régions (12') de type p,
(b) déposer une couche épitaxiale (14) sur la surface du corps en silicium de manière à enterrer les premières et deuxièmes régions,
(c) former un masque de nitrure de silicium (18) sur une couche d'oxyde de silicium (16) préalablement au dépôt sur la surface de la couche épitaxiale,
(d) implanter un dopant de type n à travers des fenêtres dans le masque dans la couche épitaxiale de manière à former des premiers puits (20) de type n recouvrant les premières régions de type n⁺ (8) dans le corps en silicium,
(e) faire croître un oxyde (22) sur les parties non masquées de la surface de la couche épitaxiale,
(f) enlever le nitrure de silicium,
(g) implanter un dopant de type p dans la couche épitaxiale en utilisant l'oxyde qui a cru sous la forme d'un masque de manière à former des deuxièmes puits de type p (24) auto-alignés avec les premiers puits de type n (20) recouvrant les deuxièmes régions de type p (12) dans le corps de silicium,
(h) commander la conductivité en déterminant les dopants des premiers et deuxièmes puits dans la couche épitaxiale de sorte que les puits de type n rencontrent les régions enterrées de type n⁺ pour former des régions de type n combinées et que les puits de type p rencontrent les régions enterrées de type p pour former des régions de type p combinées, et
(i) former des transistors dans les régions de type n combinées et les régions de type p combinées,
caractérisé en ce que la couche épitaxiale (14) déposée au cours de l'étape (b) est en un silicium sensiblement intrinsèque très légèrement dopé de type n ayant une résistivité supérieure à 10 ohms.cm.

2. Procédé selon la revendication 1, dans lequel l'étape (a) comporte les étapes consistant à :
fournir un corps en silicium de conductivité de type p,
former un masque ayant la forme d'une couche d'oxyde sur la surface du corps,
implanter un dopant de type n dans la surface du corps à travers le masque,
diffuser le dopant de type n dans le corps en silicium pour former les premières régions de type n⁺, et
enlever de la surface du corps de silicium la couche d'oxyde de masquage.

3. Procédé selon la revendication 1, dans lequel l'étape (a) comporte les étapes consistant à :
fournir un corps en silicium (2) de conductivité de type p légèrement dopée,
former un masque d'une couche d'oxyde de silicium (4) recouvert par une couche de nitrure de silicium (6) sur la surface du corps en silicium,
implanter un dopant de type n dans la surface du corps de silicium à travers le masque,
recuire le corps en silicium à une température élevée pour diffuser le dopant n dans le corps en silicium pour former les premières régions de type n⁺ et pour former une couche d'oxyde épaisse (10) sur ces parties du corps en silicium non couvertes par la couche de nitrure de silicium de masquage,
supprimer la couche de nitrure de silicium de masquage,
implanter un dopant de type p dans la surface du corps en silicium en utilisant la couche d'oxyde épaisse comme un masque,
recuire le corps en silicium pour former les deuxièmes régions de type p (12) avec les premières régions de type n⁺ (8), et
enlever l'oxyde de silicium de la surface du corps en silicium.

4. Procédé selon la revendication 1,2 ou 3, dans lequel la couche épitaxiale (14) a une épaisseur comprise entre 0,75 et 1,5 micron.

5. Procédé selon l'une quelconque des revendications précédentes, comportant en outre la formation de régions d'isolation additionnelles entre les premiers puits de type n et les deuxièmes puits de type p en implantant les dopants de type p supplémentaires sous la forme d'un arrêt du canal dans les régions isolantes.

6. Procédé selon l'une quelconque des revendications 1 à 4, comportant la formation de tranchées isolantes (40) entre les puits dans la couche épitaxiale et dans le corps en silicium à une profondeur supérieure à celle des régions enterrées.
